# EUROPÄISCHE PATENTSCHRIFT

(11) **EP 1 931 592 B1**
(45) Veröffentlichungstag und Bekanntmachung des Hinweises auf die Patenterteilung: **04.07.2018**
(21) Anmeldenummer: 06793795.3
(22) Anmeldetag: 25.09.2006
(51) Int. Cl.: B81C 1/00

(54) **VERFAHREN ZUR HERSTELLUNG EINER EINE MONOLITHISCH INTEGRIERTE SCHALTUNG UMFASSENDE SENSORANORDNUNG**
METHOD FOR PRODUCING A SENSOR ARRANGEMENT COMPRISING A MONOLITHICALLY INTEGRATED CIRCUIT
PROCEDE POUR PRODUIRE UN DISPOSITIF DE DETECTION COMPRENANT UN CIRCUIT INTEGRE MONOLITHIQUE

(30) Priorität: 27.09.2005 DE 102005046058
(43) Veröffentlichungstag der Anmeldung: 18.06.2008
(73) Patentinhaber: ROBERT BOSCH GMBH, 70442 Stuttgart (DE)
(72) Erfinder: BENZEL, Hubert, 72124 Pliezhausen (DE); ARMBRUSTER, Simon, 72810 Gomaringen (DE)
(86) Internationale Anmeldenummer: PCT/EP2006/066687
(87) Internationale Veröffentlichungsnummer: WO 2007/036504

(56) Entgegenhaltungen:
- UDREA F ET AL: "SOI CMOS gas sensors" PROCEEDINGS OF IEEE SENSORS 2002. ORLANDO, FL, JUNE 12 - 14, 2002, IEEE INTERNATIONAL CONFERENCE ON SENSORS, NEW YORK, NY : IEEE, US, Bd. VOL. 1 OF 2. CONF. 1, 12. Juni 2002 (2002-06-12), Seiten 1379-1384, XP010605321 ISBN: 0-7803-7454-1
- YOON E ET AL: "A monolithic RMS-DC converter using planar diaphragm structures" IEDM, 3. Dezember 1989 (1989-12-03), Seiten 491-494, XP010079903
- TADIGADAPA S: "Integration of micromachined devices and microelectronic circuits: techniques and challenges" CIRCUITS AND SYSTEMS, 2000. PROCEEDINGS OF THE 43RD IEEE MIDWEST SYMPOSIUM ON AUGUST 8-11, 2000, PISCATAWAY, NJ, USA,IEEE, Bd. 1, 8. August 2000 (2000-08-08), Seiten 224-227, XP010558115 ISBN: 0-7803-6475-9

## Beschreibung

### Stand der Technik

Die Erfindung geht aus von einem Verfahren zur Herstellung einer eine monolithisch integrierte Schaltung umfassende Sensoranordnung nach der Gattung des Hauptanspruchs. Aus der Druckschrift DE 199 57 556 A1 ist ein Halbleiterdrucksensor bekannt, bei dem ein Sensorelement zusammen mit einer Auswerteelektronik auf einem Chip integriert vorgesehen sein kann. Nachteilig bei solchen integrierten Anordnungen ist es häufig, dass zur Herstellung einer solchen integrierten Anordnung einer Schaltung und einer mikromechanischen Sensorstruktur diese nacheinander hergestellt bzw. strukturiert werden müssen, was die Anzahl der Maskenebenen bzw. generell der Aufwand bei der Herstellung einer solchen Sensoranordnung erhöht. Zur Reduzierung von Kosten bei der Herstellung einer solchen Sensoranordnung ist man bestrebt, zumindest Teile der Schaltung gleichzeitig mit Teilen der Sensoranordnung herzustellen. Hierbei ist es jedoch nachteilig, dass durch die Verkoppelung von Schaltungs- und Sensorstrukturrelevanten Prozessen bestimmte Struktureigenschaften, wie beispielsweise bestimmte Abmessungen bzw. Ausdehnungen der Sensorstruktur, etwa die Dicke einer Sensormembran oder dergleichen, nicht frei kontrollierbar sind, weil bei einer Veränderung einer solchen Struktureigenschaft, beispielsweise bei einer Veränderung der Dicke einer Membranschicht, der Schaltungsteil der Sensoranordnung nicht mehr ordnungsgemäß bzw. auf seiner gesamten Lebensdauer funktioniert, weil die mit Blick auf die Sensorstruktur vorgenommene Prozessvariation im Schaltungsteil der Sensoranordnung die Auswirkung hat, dass beispielsweise die Dicke bestimmter Dotierungsbereiche nicht mehr ausreichend ist, um etwa eine Isolation zu bewirken oder dergleichen.

Aus der Schrift Udrea F et Al. "SOI CMOS gas Sensors", Proceedings of IEEE Sensors 2002, June 12 - 14, 2002, IEEE International Conference on Sensors, Bd. Vol. 1 of 2. CONF. 1, Seiten 1379-1384 ist ein Aufbau eines Gassensors bekannt, bei dem ein SOI-Sensorelement in mikromechanischer Bauweise neben einem in CMOS-Bauweise elektronischen Bauelement erzeugt worden ist.

### Vorteile der Erfindung

Das erfindungsgemäße Verfahren zur Herstellung einer eine monolithisch integrierte Schaltung umfassende Sensoranordnung und die erfindungsgemäße Sensoranordnung gemäß den Merkmalen der nebengeordneten Ansprüche hat demgegenüber den Vorteil, dass unabhängig voneinander eine Optimierung der Herstellungsprozesse hinsichtlich der Schaltung als auch der mikromechanischen Sensorstruktur durchgeführt werden kann. Wenn beispielsweise eine bestimmte Maskenebene zur Erzeugung einer bestimmten Dotierung führt, welche im Schaltungsteil eine Isolierungsdotierung bereitstellt und welche bei der Sensorstruktur einen Dotierungsbereich zur Definition eines Ätzstopps zur reproduzierbar gleichförmigen Erzeugung einer Membran einer bestimmten Dicke führt, so ist es erfindungsgemäß möglich, dass die Struktureigenschaft der Dicke der Membran der Sensorstruktur variierbar ist - etwa für unterschiedliche Druckbereiche der Sensoranordnung einstellbar ist - und trotzdem eine immer gleichbleibende Dotierung im Schaltungsbereich der Sensoranordnung folgt. Das erfindungsgemäße Verfahren weist eine erste der Sensorstruktur zugeordnete Teilstruktur einen ersten Dotierungsbereich und eine zweite der Schaltung zugeordnete Teilstruktur einen zweiten Dotierungsbereich auf, wobei die erste Teilstruktur gleichzeitig mit der zweiten Teilstruktur erzeugt wird und wobei im Mittel in den ersten Dotierungsbereich eine gegenüber einer im zweiten Dotierungsbereich eingebrachten zweiten Dotierstoffkonzentration geringere erste Dotierstoffkonzentration eingebracht wird. Dies hat den Vorteil, dass mit einfachen Mitteln eine Prozessvariation und damit eine Optimierung der zur Herstellung der Sensorstruktur notwendigen Prozessabläufe vorgenommen werden kann, ohne dass die Prozessabläufe hinsichtlich der Schaltung der Sensoranordnung verändert werden.

Bevorzugt ist, dass die erste Teilstruktur ein erster Dotierungsbereich und die zweite Teilstruktur ein zweiter Dotierungsbereich ist und/oder dass die Struktureigenschaft eine bestimmte Abmessung der Sensorstruktur ist. Dies hat den Vorteil, dass die Prozessvariation besonders einfach, reproduzierbar und robust mittels einfacher Herstellungsschritte zur Herstellung von mikromechanischen Bauelementen bzw. zur Herstellung von Halbleiterschaltungen realisierbar ist, wie etwa unterschiedliche Dotierungsbereiche unterschiedliche Stärke der Dotierung oder dergleichen. Hierbei ist erfindungsgemäß insbesondere vorgesehen, dass sich die letztendlich bei der fertigen Sensoranordnung einstellende Dotierstoffkonzentration durch die Anwendung eines Diffusionsprozesses ausbildet, welcher beispielsweise bei erhöhter Temperatur der bereits dotierten Bereiche der Sensoranordnung durchgeführt wird.

Weiterhin ist bevorzugt, dass die Prozessvariation mittels einer Variation der im Mittel in den ersten Dotierungsbereich eingebrachten und gegenüber der in den zweiten Dotierungsbereich eingebrachten zweiten Dotierstoffkonzentration geringeren ersten Dotierstoffkonzentration erfolgt. Hierdurch kann die Gesamtmenge der in die Dotierungsbereiche eingebrachten Dotierstoffe zwischen dem ersten Dotierungsbereich und dem zweiten Dotierungsbereich eingestellt werden, was nach einem Diffusionsschritt beispielsweise zu einer dickeren Dotierungsschicht oder einer dünneren Dotierungsschicht führt. Bevorzugt ist erfindungsgemäß insbesondere, dass die erste Teilstruktur und die zweite Teilstruktur mittels derselben Maskenebene hergestellt werden. Dies hat den wesentlichen Vorteil, dass Herstellungskosten zur Erzeugung der Sensoranordnung eingespart werden können, weil ein und dieselbe Maske bzw. ein und dieselbe Maskenebene sowohl für die Herstellung der Schaltung als auch für die Herstellung der Sensorstruktur verwendet werden kann.

Es ist erfindungsgemäß ferner bevorzugt, dass die erste Dotierstoffkonzentration in den ersten Dotierungsbereich mittels einer gitterartigen Strukturierung der ersten Teilstruktur eingebracht wird, wobei die gitterartige Strukturierung mittels abwechselnd ersten Teilbereichen und zweiten Teilbereichen vorgesehen ist, wobei in die ersten Teilbereiche zunächst die zweite Dotierstoffkonzentration eingebracht wird und wobei in die zweiten Teilbereiche kein Dotierstoff eingebracht wird. Auf diese Weise ist es durch Variation der geometrischen Abmessungen der verschiedenen Teilbereiche, in welche unterschiedliche Dotierstoffkonzentrationen eingebracht werden können, möglich, die Gesamtmenge an Dotierstoffen, welche in den ersten Dotierungsbereich eingebracht wird, zu steuern.

Ein weiterer Gegenstand der vorliegenden Erfindung ist eine Sensoranordnung mit einer monolithisch integrierten Schaltung und einer mikromechanischen Sensorstruktur, wobei eine erste der Sensorstruktur zugeordnete Teilstruktur einen ersten Dotierungsbereich und eine zweite der Schaltung zugeordnete Teilstruktur einen zweiten Dotierungsbereich aufweist, wobei die Erzeugung der ersten Teilstruktur gleichzeitig mit der Erzeugung der zweiten Teilstruktur vorgesehen ist und wobei im Mittel in dem ersten Dotierungsbereich eine gegenüber der in dem zweiten Dotierungsbereich vorliegenden zweiten eingebrachten Dotierstoffkonzentration geringere erste eingebrachte Dotierstoffkonzentration vorgesehen ist. Hierdurch ist es mit besonders einfachen Mitteln möglich, durch Variation der ersten Dotierstoffkonzentration eine Prozessvariation zur Erzeugung einer Variation einer Struktureigenschaft der Sensorstruktur, insbesondere eine bestimmte Abmessung der Sensorstruktur, bereit zu stellen. Bevorzugt ist, dass die Einbringung der ersten Dotierstoffkonzentration mittels einer in den ersten Dotierungsbereich ausgebildeten gitterartigen Strukturierung der ersten Teilstruktur vorgesehen ist, wobei die gitterartige Strukturierung mittels abwechselnd ersten Teilbereichen höherer Dotierstoffkonzentration und zweiten Teilbereichen geringerer Dotierstoffkonzentration ausgebildet vorgesehen ist. Hierdurch ist es mit einfachen Mitteln möglich, die erste Dotierstoffkonzentration, welche im Mittel im ersten Dotierungsbereich vorliegt, zu variieren.

### Zeichnungen

Ausführungsbeispiele der Erfindung sind in der Zeichnung dargestellt und in der nachfolgenden Beschreibung näher erläutert.

Es zeigen
**Figuren 1 und 2** jeweils einen Querschnitt durch eine bekannte Sensoranordnung mit einer integrierten Schaltung und einer mikromechanischen Sensorstruktur,
**Figur 3** Schnittdarstellungen zur Erläuterung von Prozessschritten zur Erzeugung einer ersten Ausführungsform einer erfindungsgemäßen Sensorstruktur,
**Figur 4** schematische Darstellungen von Draufsichten auf verschiedene Varianten der Strukturierung eines ersten Dotierungsbereichs und
**Figur 5** Querschnittdarstellungen verschiedener Herstellungsschritte zur Erzeugung einer zweiten Ausführungsform einer erfindungsgemäßen Sensoranordnung.

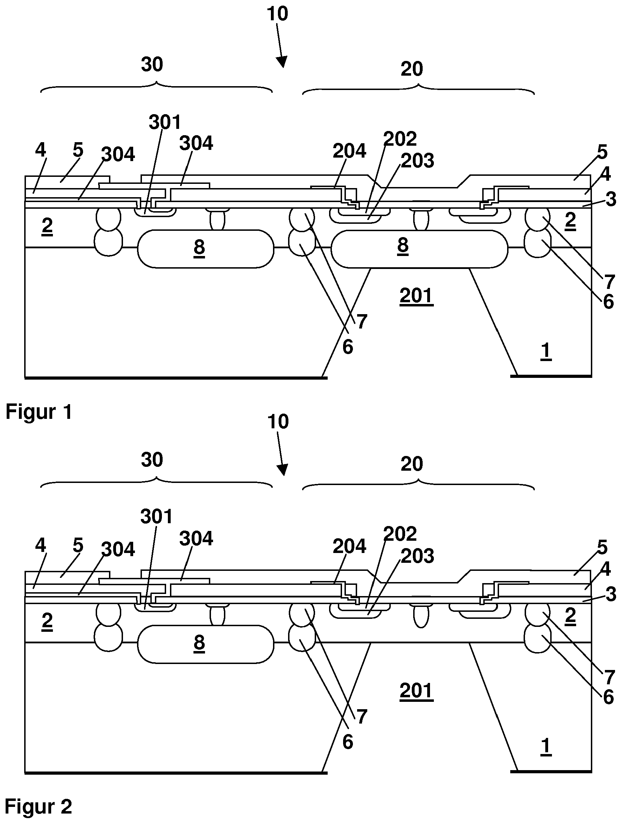

In den **Figuren 1 und 2** ist eine Querschnittdarstellung einer bekannten Sensoranordnung 10 dargestellt, wobei die mikromechanische Struktur 20 zusammen mit einem Schaltungsteil 30 bzw. einer elektronischen Schaltung 30 monolithisch integriert vorgesehen ist. Die Sensorstruktur 20 weist beispielhaft eine Kaverne 201 auf, oberhalb der eine Membranstruktur angedeutet ist, welche unterschiedliche Bereiche umfasst und auf eine Druckänderung bzw. allgemein auf eine Kraftänderung auf einer Seite (Oberseite oder Unterseite) der Membran hin ein elektrisches Signal 4 liefert. Die integrierte elektronische Schaltung 30, welche im linken Teil der Figur 1 und der Figur 2 angedeutet ist, ist erfindungsgemäß dafür vorgesehen, die Messeinrichtungen innerhalb der Sensorstruktur 20 anzusteuern, deren Signale auszuwerten und die Aufbereitung - etwa die Abgleichung oder die Anpassung oder dergleichen - zu übernehmen. Die Sensoranordnung 10 ist auf einem Substrat 1 bzw. einem Substratmaterial 1 aufgebaut, wobei es sich bei dem Substratmaterial 1 insbesondere um ein Halbleitermaterial handelt, beispielsweise monokristallines Siliziummaterial. Oberhalb des Substratmaterials 1 kann beispielsweise eine Epitaxieschicht 2 aufgebracht sein, welche vorzugsweise ebenfalls aus einem Halbleitermaterial, insbesondere Silizium besteht. Oberhalb der Epitaxieschicht 2 ist beispielhaft eine Isolationsschicht 3, etwa aus Siliziumdioxidmaterial oder einer anderen isolierenden Schicht vorgesehen. Zur elektrischen Isolierung verschiedener Kontaktierungsleitungen und zum Schutz der Sensoranordnung 10 bzw. des Sensors 10 können weitere Isolationsschichten, etwa eine erste Nitridschicht 4 und eine zweite Nitridschicht 5 vorgesehen sein. Weitere Dotierungen 6, 7 und 8, welche zur Funktion der Schaltung 30 bzw. der Sensorstruktur 20 benötigt werden, sind ebenfalls in das Substratmaterial 1 eingebracht. Hierbei handelt es sich bei der mit dem Bezugszeichen 6 versehenen Dotierung etwa um eine sogenannte untere Isolierung (auch als "Bottom Isolation" bezeichnet), bei der mit dem Bezugszeichen 7 versehenen Dotierung um eine obere Isolierung (auch als "Upper Isolation" bezeichnet) und bei der mit dem Bezugszeichen 8 versehenen Dotierung um eine Leitschichtdotierung (auch als "Buried Layer" bezeichnet).

Beispielhaft für die Schaltung 30 ist im linken Teil der Figur 1 ein Schaltungselement dargestellt, welches in herkömmlicher Weise funktionale Bereiche 301 aufweist, wobei verschiedene Teile des Schaltungselementes mittels Kontaktierungsleitungen 304 mit anderen Teilen der Schaltung 30 verbunden sind. Ebenso ist im rechten Teil der Figur 1 im Bereich der Sensorstruktur 20 in bekannter Weise ein Messelement 202 innerhalb der Membranstruktur und oberhalb der Kaverne 201 vorgesehen, wobei eine Kraftausübung auf eine Seite der Membran zu einer Auslenkung derselben führt, welche infolge einer Materialspannung im Bereich des Messelementes 202 zu einem auswertbaren Signal führt. Hierzu umfasst die Sensorstruktur 20 insbesondere Isolations- bzw. Zuleitungsbereiche 203 sowie eine Kontaktierungsleitung 204 zum Anschluss des Messelementes 202.

Die bisher beschriebenen Elemente der Sensoranordnung sind aus dem Stand der Technik bekannt und wiederholen sich in den nachfolgenden Figuren, wobei sie jedoch nicht einzeln nochmals bezeichnet werden.

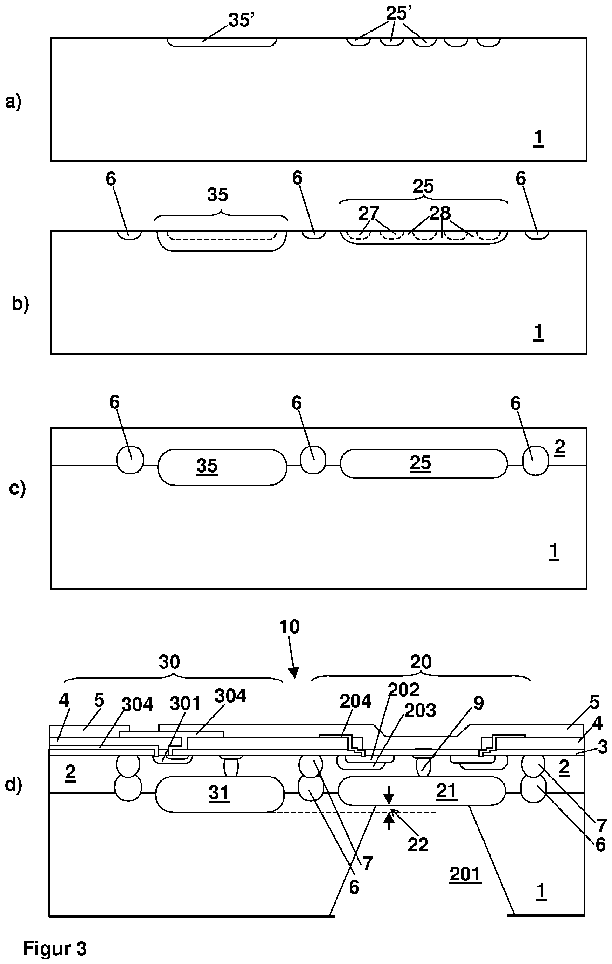

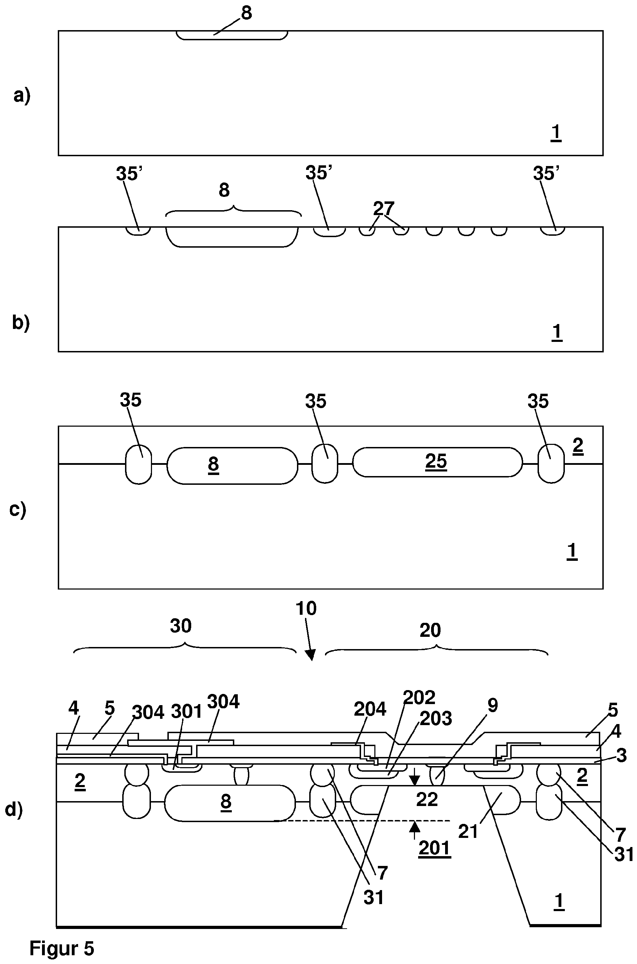

Erfindungsgemäß kann sowohl die untere Isolierung 6 (zweites Ausführungsbeispiel, Figur 5) als auch die Leitschichtdotierung 8 (erstes Ausführungsbeispiel, Figur 3) die Funktionen von ersten bzw. zweiten Teilstrukturen 21, 31 bzw. von ersten bzw. zweiten Dotierungsbereichen 25, 35 übernehmen.

Die in den Figuren 1 bzw. 2 dargestellten Sensoranordnungen weisen in ihrem Schaltungsteil 30 beispielsweise die Leitschichtdotierung 8 auf, die im ersten Ausführungsbeispiel der Erfindung (Figur 3) die Funktion der zweiten Teilstruktur 31 bzw. des zweiten Dotierungsbereichs 35 übernimmt. Erfindungsgemäß ist diese Leitschichtdotierung 8 (bzw. zweite Teilstruktur 31) für die Funktion die Schaltung 30 zwingend erforderlich und eine Variation der Leitschichtdotierung 8 würde sich funktionsverschlechternd auf die Schaltung 30 auswirken. Am Beispiel der Figur 1 wird deutlich, dass (insbesondere zur Erzielung geringer Herstellungskosten der Sensoranordnung) mittels des gleichen Herstellungsschritts wie für die Leitschichtdotierung 8 im Bereich der Sensorstruktur 20 ebenfalls eine Dotierung 8 eingebracht ist, die im ersten Ausführungsbeispiel der Erfindung (Figur 3) die Funktion der ersten Teilstruktur 21 bzw. des ersten Dotierungsbereichs 25 übernimmt. Diese Dotierung 8 im Bereich der Sensorstruktur 20 dient der Einstellung einer bestimmten Struktureigenschaft der Sensorstruktur, etwa einer Abmessung der Sensorstruktur wie beispielsweise eine Dicke einer Sensormembran oder dergleichen. Zur Optimierung des Herstellungsprozesses zur Erzeugung der Sensorstruktur 20 kann es notwendig sein, die Struktureigenschaft, also etwa die Dicke einer Membran, zu verändern, beispielsweise um unterschiedliche Drücke mit besonders hoher Messempfindlichkeit detektieren zu können. Eine solche Variation einer Struktureigenschaft kann nun bei bekannten Sensoranordnungen gemäß den Figuren 1 und 2 nicht durch eine Variation beispielsweise der Dicke der Dotierung 8 variiert werden, weil dies wegen ihrer gleichzeitigen Erzeugung Auswirkungen hätte auf den Schaltungsteil 30 der Sensoranordnung 10. Es müssen daher beim Stand der Technik gegebenenfalls kostenträchtige Umgehungslösungen (beispielsweise mittels einer Sonderdotierung) entwickelt werden bzw. es kann die Struktureigenschaft überhaupt nicht oder nur in unzureichender Weise verändert werden. In Figur 2 ist die Dotierung 8 vollkommen weggelassen worden, d. h. es ist bei der Erzeugung der Leitschichtdotierung 8 (für den Schaltungsteil) eine solche Ätzmaske bzw. Strukturierungsmaske verwendet worden, dass im Bereich der Sensorstruktur 20 keinerlei Dotierung 8 erzeugt wird. Dies führt dazu, dass als Ätzstopp zur Erzeugung der Kaverne 201 nicht die Dotierung 8 (wie bei der Figur 1) Verwendung findet, sondern der Übergang zwischen dem Substratmaterial 1 und der Epitaxieschicht 2, an dem ebenfalls ein Ätzstopp für die Ätzung der Kaverne 201 (insbesondere KOH-Ätzung, mit einem PN-Übergang als Ätzstopp) angeordnet sein kann. Hierdurch ist es jedoch lediglich möglich, entweder eine sehr dicke Membran (vgl. Figur 1) oder eine sehr dünne Membran (vgl. Figur 2) zu realisieren, so dass keine Membrandicken zwischen diesen Extremen zur Bereitstellung etwa eines Drucksensors im Übergangsbereich zwischen hohen und niedrigen Drücken möglich ist.

In **Figur 3** ist nun eine erfindungsgemäße erste Ausführungsform eines Verfahrens schematisch dargestellt, welches zur Erzeugung einer ersten Ausführungsform einer erfindungsgemäßen Sensoranordnung 10 (Figur 3d) führt, wobei die Membrandicke variierbar ist. In Figur 3a ist zunächst ein Zwischenstadium zur Herstellung der erfindungsgemäßen Sensoranordnung 10 dargestellt, wobei in das Substratmaterial 1 eine erste Vorläuferdotierung 25' eines ersten Dotierungsbereiches und eine zweite Vorläuferdotierung 35' eines zweiten Dotierungsbereiches eingebracht ist. In Figur 3b ist die Situation nach der Durchführung eines Diffusionsprozesses dargestellt (insbesondere thermischer Diffusionsprozess), wobei sich, ausgehend von den Vorläuferdotierungen 25', 35', ein erster Dotierungsbereich 25 und ein zweiter Dotierungsbereich 35 gebildet hat. Innerhalb des ersten Dotierungsbereiches 25 ist erkennbar, dass dieser erste Teilbereiche 27 und zweite Teilbereiche 28 umfasst, wobei in den ersten Teilbereichen 27 (die der ersten Vorläuferdotierung 25' entsprechen) gleichzeitig mit der Realisierung der zweiten Vorläuferdotierung 35' ein Dotierstoff mit einer bestimmten Dotierstoffkonzentration eingebracht wird. In die zweiten Teilbereiche 28, welche sich abwechselnd zwischen bzw. neben den ersten Teilbereichen 27 befinden, wird kein Dotierstoff gleichzeitig zur Dotierung der zweiten Vorläuferdotierung 35' eingebracht. Für den ersten Dotierungsbereich 25 hat dies gegenüber dem zweiten Dotierungsbereich 35 die Folge, dass sich innerhalb des ersten Dotierungsbereiches 25 im Mittel lediglich eine geringere erste Dotierstoffkonzentration einstellt als im zweiten Dotierungsbereich 35, welcher eine zweite Dotierstoffkonzentration aufweist. Die unterschiedlichen eingebrachten Dotierstoffkonzentrationen im ersten und zweiten Dotierungsbereich 25, 35, bzw. insbesondere die unterschiedlichen Dotierstoffmengen, bewirken, dass der erste Dotierungsbereich 25 eine geringere Eindringtiefe in das Substratmaterial aufweist als der zweite Dotierungsbereich 35. Hierdurch wird bei der Herstellung der Kaverne 201 durch Rückseitenätzung, insbesondere mittels KOH-Ätzung, ein Ätzstopp in einer anderen Höhe, d. h. zur Realisierung einer unterschiedlichen Membrandicke, hervorgerufen.

In Figur 3c ist die Situation nach dem Aufbringen der Epitaxieschicht 2 dargestellt. Der erste Dotierungsbereich 25 behält seine gegenüber der Dicke des zweiten Dotierungsbereiches 35 geringere Dicke bzw. Tiefe in dem Substratmaterial 1 bei.

In Figur 3d ist die erste Ausführungsform der erfindungsgemäßen Sensoranordnung 10 dargestellt. Gegenüber der Anordnung in Figur 1, bei der eine vollkommen parallele Prozessierung zur Erzeugung der ersten Teilstruktur 21 und der zweiten Teilstruktur 31 vorgenommen wurde, bewirkt die geringere Dicke des ersten Dotierungsbereiches 25 in der Figur 3, dass die Dicke der Sensormembran um die mit dem Bezugszeichen 22 bezeichnete Längendifferenz verringert ausgebildet ist. Zur Realisierung des Ätzstopps an der Unterseite des ersten Dotierungsbereiches 25 bzw. an der Unterseite der ersten Teilstruktur 21 ist erfindungsgemäß ein Kontaktierungsbereich 9 vorgesehen, der eine vergleichsweise niederohmige Anbindung der ersten Teilstruktur 21 an eine (nicht dargestellte) Kontaktfläche bzw. Anschlussleitung realisiert.

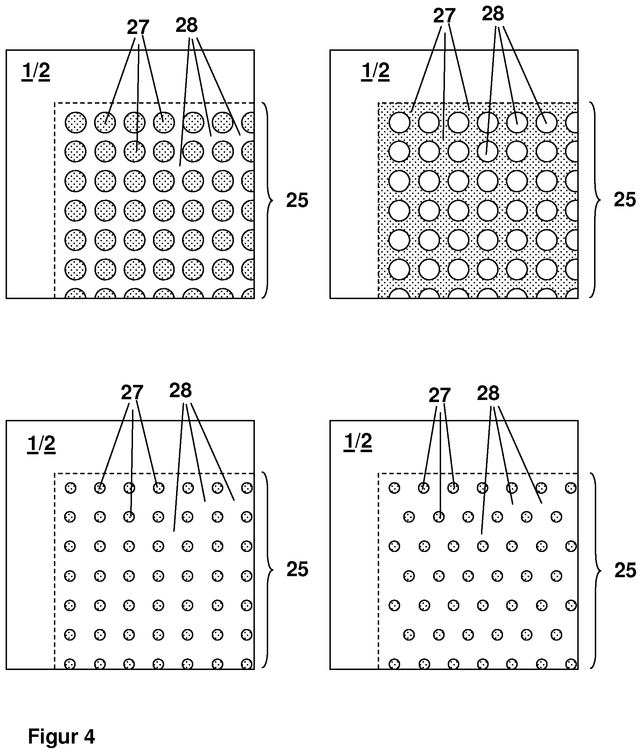

In **Figur 4** sind mehrere Ausführungsformen zur Strukturierung des ersten Dotierungsbereiches 25 angegeben, welche beispielhafte Realisierungen einer solchen Strukturierung darstellen. Im oberen linken Teil der Figur 4 ist beispielhaft eine Andeutung mit kreisrunden ersten Teilbereichen 27 angegeben, in welchen der auch zur Erzeugung des zweiten Dotierungsbereiches 35 verwendete Dotierstoff in das Substratmaterial 1 eingebracht wird. Zwischen den ersten Teilbereichen 27 sind alternierend angeordnet zweite Teilbereiche 28 vorgesehen, in welchen durch eine Maske abgedeckt keinerlei Dotierstoff in das Substratmaterial 1 eingebracht wird. Im Mittel ergibt sich daher in der ersten Teilstruktur 21 bzw. im ersten Dotierungsbereich 25 eine geringere Dotierstoffmenge (pro Fläche), die (nach einem Diffusionsprozess) zu einer geringeren Dicke des ersten Dotierungsbereiches 25 im Vergleich zum zweiten Dotierungsbereich 35 (vgl. Figur 3c) führt. Im oberen rechten Teil der Figur 4 ist eine inverse Anordnung der Verteilung der ersten Teilbereiche 27 und der zweiten Teilbereiche 28 angegeben. Hierbei ist die Strukturierungsmaske bei der Einbringung des Dotierstoffes in den ersten und zweiten Dotierungsbereich 25, 35 invers ausgebildet, so dass um die kreisrund vorgesehenen zweiten Teilbereiche 28, welche die Bereiche angeben, in denen kein Dotierstoff in das Substratmaterial 1 eingebracht wird, von den ersten Teilbereichen 27 vollkommen umgeben sind. Zur weiteren Variierung der Dotierstoffmenge im ersten Dotierungsbereich 25 kann weiterhin die relative Verteilung von ersten und zweiten Teilbereichen verändert werden, vgl. untere linke Darstellung der Figur 4, in der die ersten Teilbereiche 27 kleiner ausgebildet sind und so die Fläche, auf welcher die zur Erzeugung der zweiten Teilstruktur 31 bzw. des zweiten Dotierungsbereiches 35 notwendige Dotierstoffkonzentration eindringen kann, verkleinert wird. Im rechten unteren Teil der Figur 4 ist eine hexagonale Anordnung der ersten Teilbereiche 27 und der zweiten Teilbereiche 28 dargestellt.

In **Figur 5** ist eine zweite Ausführungsform eines erfindungsgemäßen Herstellungsverfahrens zur Erzeugung einer erfindungsgemäßen Sensoranordnung 10 dargestellt, wobei bei der zweiten Ausführungsform eine weitere Reduzierung der Membrandicke (vgl. die Differenz 22 in der Membrandicke in Figur 5d) dadurch erzielt wird, dass die erste Teilstruktur 21 gemeinsam mit der in den Figuren 1 und 2 mit dem Bezugszeichen 6 bezeichnete untere Isolierung des Schaltungsbereiches 30 durchgeführt wird, welche in der zweiten Ausführungsform der erfindungsgemäßen Sensoranordnung 10 damit als die zweite Teilstruktur 31 aufgefasst wird. Die in der ersten Ausführungsform (Figur 3) der erfindungsgemäßen Sensoranordnung 10
benutzte Diffusion für die zweite Teilstruktur 31 ist für den Schaltungsteil 30 der Sensoranordnung 10 weiterhin notwendig und in der Figur 5 mit dem Bezugszeichen 8 bezeichnet. Die in der ersten Ausführungsform der erfindungsgemäßen Sensoranordnung 10 bzw. des Verfahrens zu deren Herstellung mit dem Bezugszeichen 6 bezeichnete Diffusion, welche einer sogenannten unteren Isolierung der Sensoranordnung 10 entspricht, wird bei der zweiten Ausführungsform der erfindungsgemäßen Sensoranordnung 10 als zweite Teilstruktur 31 herangezogen und gemeinsam mit der ersten Teilstruktur 21 ausgebildet bzw. prozessiert. Die Diffusionen der unteren Isolierung 6 werden beispielsweise nach der Diffusion der Leitschichtdotierung 8 ausgeführt und führen zu einer Vorläuferdotierung 35' des zweiten Dotierungsbereiches 35 (vgl. Figuren 5a und b). Im Bereich des ersten Dotierungsbereiches 25 ist wiederum eine Strukturierung derart vorgesehen, dass der erste Dotierungsbereich 25 (vgl. Figur 5c) eine geringere Menge an Dotierstoff pro Fläche erhält als die zweite Teilstruktur 31 bzw. der zweite Dotierungsbereich 35. Hierzu ist in zum ersten Ausführungsbeispiel analoger Weise die erste Teilstruktur 21 bzw. der erste Dotierungsbereich 25 abwechselnd in erste Teilbereiche 27 und zweite Teilbereiche 28 aufgeteilt, wie dies beispielhaft in Figur 4 dargestellt ist. Im Resultat führt dies bei der zweiten Ausführungsform der erfindungsgemäßen Sensoranordnung 10 (vgl. Figur 5d) dazu, dass die Grenze zwischen dem ersten Dotierungsbereich 25 und der Epitaxieschicht 2 als Ätzstopp für die Bildung der Kaverne 201 fungiert.

Erfindungsgemäß kann somit die Dicke der Membranschicht im Bereich der Sensorstruktur 30 in weiten Grenzen variiert werden, ohne dass Prozesse zur Herstellung des Schaltungsbereiches 20 verändert werden müssen. Hierbei kann eine Änderung der Membrandicke sogar vergleichsweise kontinuierlich erfolgen, so dass eine Optimierung der Herstellung der Sensorstruktur 20 möglich ist. Außerdem ist es erfindungsgemäß dadurch möglich, eine optimale Anpassung der Membrandicke an den zu sensierenden Druckbereich vorzunehmen. Erfindungsgemäß ist es sowohl möglich, die Membranstruktur als Absolutdrucksensor oder als Differenzdrucksensor zu verwenden. Insbesondere ist es aufgrund der Möglichkeit, eine vergleichsweise dünne Membran zu erzeugen, möglich, dass Niederdrucksensoren hergestellt werden, wo es auf eine hohe Empfindlichkeit der Drucksensoranordnung ankommt, beispielsweise für Tankdrucksensoren. Durch die Möglichkeit, besonders dünne Membranen herzustellen, kann das Verfahren für Sensoren angewendet werden, wo es auf besonders geringe Chipkosten ankommt, weil bei gleicher Empfindlichkeit der Membrananordnung eine deutlich kleinere Membran durch die geringere Dicke der Membran realisiert werden kann. Erfindungsgemäß ist es vorteilhaft, dass die Membrandicke gesteuert und angepasst werden kann und dennoch eine reproduzierbar gleichbleibende Membrandicke durch die Anordnung eines PN-Ätzstopps realisierbar ist, wobei keine neuen oder zusätzlichen Prozessschritte und/oder Maskenebenen notwendig sind. Erfindungsgemäß kann somit eine Trennung der Optimierung der Sensorstruktur 20 von einer Optimierung der Schaltungsstruktur erfolgen. Durch entsprechende Anordnung der ersten Teilbereiche 27 und der zweiten Teilbereiche 28 innerhalb des ersten Dotierungsbereiches 25 ist es möglich, dass nach einer thermischen oder sonstigen Diffusion des Dotierstoffes ein zusammenhängendes Gebiet (erster Dotierungsbereich 25) ausbildet, in dem eine entsprechend hohe Konzentration des Dotierstoffes (erste Dotierstoffkonzentration) vorliegt, um als Ätzstopp fungieren zu können, wobei diese Konzentration des Dotierstoffes jedoch geringer ist, als die zweite Dotierstoffkonzentration im zweiten Dotierungsbereich 35 bzw. in der zweiten Teilstruktur 31 der erfindungsgemäßen Sensoranordnung 10.

Bei dem Substratmaterial 1 handelt es sich insbesondere um ein schwach positiv dotiertes Siliziummaterial. Bei der Epitaxieschicht 2 handelt es sich insbesondere um eine schwach negativ dotierte Epitaxieschicht 2. Bei der Leitschichtdotierung 8 (Figur 5) handelt es sich insbesondere um einen vergleichsweise stark negativ dotierten Bereich, so dass sich zwischen dieser Leitschichtdotierung und dem Substrat 1 ein PN-Übergang mit Ätzstoppverhalten ergibt, insbesondere dann, wenn die Leitschicht über den Kontaktierungsbereich 9 auf einem entsprechenden Potential gegenüber dem Ätzmedium zur Ätzung der Kaverne 201 gehalten wird. Die Dotierung der unteren Isolation (Dotierung 6 in Figur 3 bzw. zweiter Dotierungsbereich 35 in Figur 5) ist insbesondere als eine vergleichsweise stark positive Dotierung vorgesehen, so dass sich gegenüber der Epitaxieschicht ein Ätzstoppverhalten ergibt.

Je nach gewünschter Membrandicke und damit der Dicke des ersten Membranbereiches 25 können unterschiedliche Gittergeometrien der ersten Teilbereiche 27 und der zweiten Teilbereiche 28 mit unterschiedlichen Loch- zu Stegverhältnissen verwendet werden. Insbesondere ist es möglich, eine rechteckige Konfiguration (Figur 4, außer der unteren rechten Anordnung) oder eine hexagonale Anordnung (Figur 4, untere rechte Anordnung) zu wählen. Erfindungsgemäß sind selbstverständlich auch weitere Gittergeometrien denkbar. Auch die Form der ersten Teilbereiche 27 bzw. der zweiten Teilbereiche 28 ist erfindungsgemäß beliebig wählbar. Statt der in Figur 4 bezeichneten runden Ausführung ist beispielsweise auch eine quadratische oder eine rechteckige Struktur oder auch eine zusammenhängende, beispielsweise mäanderförmige oder sonstige Strukturierung der ersten und zweiten Teilbereiche möglich.

## Patentansprüche

1. Verfahren zur Herstellung einer Sensoranordnung (10), welche
- eine monolithisch integrierte Schaltung (30) und
- eine mikromechanische Sensorstruktur (20) aufweist,
wobei
- die Sensorstruktur (20) eine erste Teilstruktur (21) und
- die Schaltung (20) eine zweite Teilstruktur (31)
aufweist,
wobei zur Erzeugung der ersten Teilstruktur (21) ein erster Dotierungsbereich (25) und zur Erzeugung der zweiten Teilstruktur (31) ein zweiter Dotierungsbereich (35) in einem Substrat (1) erzeugt wird,
**dadurch gekennzeichnet dass**
der erste und der zweite Dotierungsbereich im gleichen Diffusionsprozess erzeugt werden,
wobei während des Diffusionsprozess in den ersten Dotierungsbereich (21, 25) eine erste Dotierstoffkonzentration und in den zweiten Dotierungsbereich (31, 35) eine zweite Dotierstoffkonzentration eingebracht wird,
wobei die erste Dotierstoffkonzentration geringer als die zweite Dotierstoffkonzentration ist.

2. Verfahren nach Anspruch 1, **dadurch gekennzeichnet, dass** die Sensorstruktur (20) eine Membran aufweist, wobei die Dicke der Membran durch die Vorgabe der Dotierung im ersten Dotierungsbereich eingestellt wird.

3. Verfahren nach einem der vorhergehenden Ansprüche, **dadurch gekennzeichnet, dass** die erste Teilstruktur (21) und die zweite Teilstruktur (31) mittels derselben Maskenebene hergestellt werden.

4. Verfahren nach einem der vorhergehenden Ansprüche, **dadurch gekennzeichnet, dass** die erste Dotierstoffkonzentration in den ersten Dotierungsbereich (25) mittels einer gitterartigen Strukturierung der ersten Teilstruktur (21) eingebracht wird, wobei die gitterartige Strukturierung mittels abwechselnd ersten Teilbereichen (27) und zweiten Teilbereichen (28) vorgesehen ist, wobei in die ersten Teilbereiche (27) die zweite Dotierstoffkonzentration eingebracht wird und wobei in die zweiten Teilbereiche (28) kein Dotierstoff eingebracht wird.

5. Verfahren nach einem der vorhergehenden Ansprüche, **dadurch gekennzeichnet, dass** die erste Teilstruktur mittels eines thermischen Diffusionsprozesses ausgehend von dem ersten Dotierungsbereich erzeugt wird.

6. Sensoranordnung (10) mit
- einer monolithisch integrierten Schaltung (30) und
- einer mikromechanischen Sensorstruktur (20),
wobei
- eine erste der Sensorstruktur (20) zugeordnete Teilstruktur (21) einen ersten Dotierungsbereich (25) und
- eine zweite der Schaltung (30) zugeordnete Teilstruktur (31) einen zweiten Dotierungsbereich (35)
aufweist,
wobei der erste Dotierungsbereich (25) eine erste Dotierstoffkonzentration und der zweite Dotierungsbereich (35) eine zweite Dotierstoffkonzentration aufweist,
**dadurch gekennzeichnet dass**
die erste Dotierstoffkonzentration geringer als die zweite Dotierstoffkonzentration ist, und
die erste Teilstruktur (21) bzw. der erste Dotierungsbereich (25) eine geringere Dicke als die zweite Teilstruktur (31) bzw. der zweite Dotierungsbereich (35) aufweist.

7. Sensoranordnung (10) nach Anspruch 6, **dadurch gekennzeichnet, dass** erste Dotierstoffkonzentration in dem ersten Dotierungsbereich (25) eine gitterartige Strukturierung in der ersten Teilstruktur (21) aufweist, wobei die gitterartige Strukturierung mittels abwechselnd ersten Teilbereichen (27) höherer Dotierstoffkonzentration und zweiten Teilbereichen (28) geringerer Dotierstoffkonzentration ausgebildet ist.

## Claims

1. Method for producing a sensor arrangement (10) comprising
- a monolithically integrated circuit (30) and
- a micromechanical sensor structure (20),
wherein
- the sensor structure (20) comprises a first substructure (21) and
- the circuit (20) comprises a second substructure (31),
wherein for producing the first substructure (21) a first doping region (25) and for producing the second substructure (31) a second doping region (35) are produced in a substrate (1),
**characterized in that**
the first and second doping regions are produced in the same diffusion process,
wherein during the diffusion process, a first dopant concentration is introduced into the first doping region (21, 25) and a second dopant concentration is introduced into the second doping region (31, 35),
wherein the first dopant concentration is lower than the second dopant concentration.

2. Method according to Claim 1, **characterized in that** the sensor structure (20) comprises a membrane, wherein the thickness of the membrane is set by the predefinition of the doping in the first doping region.

3. Method according to either of the preceding claims, **characterized in that** the first substructure (21) and the second substructure (31) are produced by means of the same mask plane.

4. Method according to any of the preceding claims, **characterized in that** the first dopant concentration is introduced into the first doping region (25) by means of a latticelike structuring of the first substructure (21), wherein the latticelike structuring is provided by means of alternately first partial regions (27) and second partial regions (28), wherein the second dopant concentration is introduced into the first partial regions (27) and wherein no dopant is introduced into the second partial regions (28).

5. Method according to any of the preceding claims, **characterized in that** the first substructure is produced by means of a thermal diffusion process proceeding from the first doping region.

6. Sensor arrangement (10) comprising
- a monolithically integrated circuit (30) and
- a micromechanical sensor structure (20),
wherein
- a first substructure (21) assigned to the sensor structure (20) comprises a first doping region (25) and
- a second substructure (31) assigned to the circuit (30) comprises a second doping region (35), wherein the first doping region (25) has a first dopant concentration and the second doping region (35) has a second dopant concentration,
**characterized in that**
the first dopant concentration is lower than the second dopant concentration, and
the first substructure (21) or the first doping region (25) has a smaller thickness than the second substructure (31) or the second doping region (35), respectively.

7. Sensor arrangement (10) according to Claim 6, **characterized in that** the first dopant concentration in the first doping region (25) has a latticelike structuring in the first substructure (21), wherein the latticelike structuring is formed by means of alternately first partial regions (27) having higher dopant concentration and second partial regions (28) having lower dopant concentration.

## Revendications

1. Procédé pour produire un dispositif de détection (10) comprenant
- un circuit intégré monolithique (30) et
- une structure de détection micromécanique (20),
dans lequel
- la structure de détection (20) comporte une première structure partielle (21), et
- le circuit (20) comporte une seconde structure partielle (31),
dans lequel une première région de dopage (25) est générée pour générer la première structure partielle (21) et une seconde région de dopage (35) est générée pour générer la seconde structure partielle (31), dans un substrat (1),
**caractérisé en ce que** les première et seconde régions de dopage sont générées par un même processus de diffusion,
dans lequel, pendant le processus de diffusion, une première concentration de dopant est introduite dans la première région de dopage (21, 25) et une seconde concentration de dopant est introduite dans la seconde région de dopage (31, 35),
dans lequel la première concentration de dopant est inférieure à la seconde concentration de dopant.

2. Procédé selon la revendication 1, **caractérisé en ce que** la structure de détection (20) comporte une membrane, dans lequel l'épaisseur de la membrane est réglée en spécifiant le dopage dans la première région de dopage.

3. Procédé selon l'une des revendications précédentes, **caractérisé en ce que** la première structure partielle (21) et la seconde structure partielle (31) sont produites au moyen d'un même plan de masquage.

4. Procédé selon l'une des revendications précédentes, **caractérisé en ce que** la première concentration de dopant dans la première région de dopage (25) est introduite au moyen d'une structuration de type réseau de la première structure partielle (21), dans lequel la structuration de type réseau est créée par alternance de premières zones partielles (27) et de secondes zones partielles (28), dans lequel la seconde concentration de dopant est introduite dans les premières régions partielles (27) et dans lequel aucun dopant n'est introduit dans les secondes régions partielles (28).

5. Procédé selon l'une des revendications précédentes, **caractérisé en ce que** la première structure partielle est générée au moyen d'un processus de diffusion thermique à partir de la première région de dopage.

6. Dispositif de détection (10) comportant
- un circuit intégré monolithique (30) et
- une structure de détection micromécanique (20),
dans lequel
- une première structure partielle (12) associée à la structure de détection (20) comporte une première région de dopage (25) et
- une seconde structure partielle (31) associée au circuit (30) comporte une seconde région de dopage (35),
dans lequel la première région de dopage (25) présente une première concentration de dopant et la seconde région de dopage (35) présente une seconde concentration de dopant,
**caractérisé en ce que** la première concentration de dopant est inférieure à la seconde concentration de dopant, et
la première structure partielle (21) ou la première région de dopage (25) présente une plus faible épaisseur que la seconde structure partielle (31) ou que la seconde région de dopage (35).

7. Dispositif de détection (10) selon la revendication 6, **caractérisé en ce que** la première concentration de dopant dans la première région de dopage (25) présente une structure de type réseau dans la première structure partielle (21), dans lequel la structuration de type réseau est réalisée au moyen d'une alternance de premières régions partielles (27) ayant une concentration de dopant plus élevée et de secondes régions partielles (21) ayant une plus faible concentration de dopant.
